# EUROPEAN PATENT APPLICATION

(11) **EP 1 814 224 A2**
(43) Date of publication of application: **01.08.2007**
(21) Application number: 06022241.1
(22) Date of filing: 24.10.2006
(51) Int. Cl.: H03K 3/356, H03K 19/0185

(54) **Level translator for converting a signal to a predetermined voltage range**

(30) Priority: 30.01.2006 US 341383
(71) Applicant: Broadcom Corporation, Irvine, CA 92618-7013 (US)
(72) Inventor: Arslan, Erol, 2605HD, Maarssen (NL); Bajdechi, Ovidiu, 2623HL Delft (NL)
(74) Representative: Jehle, Volker Armin

(57) **Abstract**

A level translator for translating a digital signal from a first voltage level to another voltage level having a higher voltage assigned to the high state of the signal comprises a latch and a pair of N-MOS transistors being coupled to the latch. This design is improved in that the N-MOS transistors are native thick oxide N-MOS transistors, each having a thin oxide layer N-MOS transistor coupled to native thick oxide transistors for reducing leakage current and improving speed in the transient state.

## Description

### BACKGROUND OF THE INVENTION

### Field of the Invention

The invention pertains to the general field of electric circuits for processing digital signals; in particular this invention pertains to a level translator.

### Background Art

The general purpose of a level translator is to translate a digital signal into a different voltage level. For example, a digital signal is assigned a first voltage level for its low state and a higher voltage level for the high state. In case that the digital signal is to be transferred from that first circuit to another circuit, wherein the high state of the signal is assigned a higher voltage level, the signal level must be adapted to that higher voltage level. For translating the signal into the higher level a level translator can be used.

Level translator circuits are used for example in chips which are needed for Ethernet networking.

Level translators in various designs are known from the state of the art. However as circuits become faster and faster and circuits preferably operate at low voltage levels, whereas signals on network wires need a certain voltage level, there is a need for voltage level translators with low power consumption.

### BRIEF SUMMARY OF THE INVENTION

The invention is aimed at providing an improved voltage level translator substantially as shown in and/or described in connection with at least one of the figures, as set forth more completely in the claims.
According to an aspect of the invention, a circuit is provided for translating a digital input signal from a first voltage level to a digital output signal of a second, higher voltage level, having a first input connector for receiving the digital input signal and a second input connector for receiving the inverted digital input signal, a first output connector for delivering the digital output signal and a second output connector for delivering the inverted digital output signal, a first voltage supply connector coupled to the high potential of a voltage supply source and a second voltage supply connector coupled to the reference voltage of the voltage supply source, comprising:
- a latch coupled to the first voltage supply connector, the higher voltage level being the output voltage level of a first and second output connector of the latch;
- a first and a second N-MOS transistor, the first N-MOS transistor coupled to the first output connector of the latch and the second N-MOS transistor coupled to the second output connector of the latch respectively , and wherein the state of the first transistor is controlled by the state of the first input connector and the state of the second N-MOS transistor is controlled by the state of the second input connector respectively;
- a first and a second switching device, the first switching device connecting the drain of the first N-MOS transistor to the second voltage supply connector and the second switching device connecting the drain of the second N-MOS transistor to the second voltage supply connector, wherein the state of the first switching device is controlled by the state of the first input connector and the state of the second switching device is controlled by the state of the second input connector and wherein the switching time of first and second switching device into the insulating OFF-state is shorter than that of the first and second N-MOS transistor.
Advantageously, the first and second N-MOS transistor each is a native thick oxide layer N-MOS transistor.
Advantageously, the first switching device is a third N-MOS transistor and the second switching device is a fourth N-MOS transistor, the third N-MOS transistor being coupled with its source to the drain of the first N-MOS transistor and with its drain to the second voltage supply connector and with its gate to the second input connector, the fourth N-MOS transistor being coupled with its source to the drain of the second N-MOS transistor and with its drain to the second voltage supply connector and with its gate to the first input connector.
Advantageously, the third and fourth N-MOS transistors are thin oxide layer N-MOS transistors.
Advantageously, the latch comprises a first and a second P-MOS transistor each coupled with its source to the first voltage supply connector and being cross-coupled in that the gate of the first P-MOS transistor is connected to the drain of the second P-MOS transistor and the gate of the second P-MOS transistor is connected to the drain of the first P-MOS transistor respectively, wherein the drain of the first thick oxide layer P-MOS transistor constitutes the first output connector and the drain of the second P-MOS transistor constitutes the second output connector respectively.
Advantageously, the first N-MOS transistor being coupled with its source to the drain of the first thick oxide P-MOS transistor and the second N-MOS transistor being coupled with its source to the drain of the second thick oxide P-MOS transistor respectively, and wherein the gate of the first N-MOS transistor is coupled to the second input connector and the gate of the second N-MOS transistor is coupled to the first input connector respectively.
Advantageously, the circuit further comprises a third and a fourth P-MOS transistor, each coupled with its source and gate to the first voltage supply connector, the drain of the third P-MOS transistor coupled to the drain of the first P-MOS transistor and the drain of the fourth P-MOS transistor coupled to the drain of the second P-MOS transistor.
Advantageously, the latch comprises a first and a second NOT gate inverter each coupled to the first voltage supply connector and to the second voltage supply connector for voltage supply, the input of each NOT gate inverter being connected to the output of the other NOT gate inverter, wherein the output connector of first NOT gate inverter constitutes the first output connector of the circuit and the output connector of second NOT gate inverter constitutes the second output connector of the circuit respectively.
Advantageously, the first N-MOS transistor being coupled with its source to the output connector of the first NOT gate inverter and the second N-MOS transistor being coupled with its source to the drain of the second thick NOT gate inverter respectively, and wherein the gate of the first N-MOS transistor is coupled to the second input connector and the gate of the second N-MOS transistor is coupled to the first input connector respectively.
Advantageously, the first voltage level is 1.0 Volts and the second, higher voltage level is 2.5 Volts.
Advantageously, each thick oxide layer N-MOS transistor is designed as a set of six parallel transistors, each transistor having a channel width of 1.0 micrometer and a channel length of 1.2 micrometer, and wherein each thin oxide layer N-MOS transistor is designed as a set of six parallel transistors, each transistor having a channel width of 1.0 micrometer and a channel length of 0.2 micrometer.
Advantageously, the transistors are implemented in 90 nanometer CMOS technology.
Advantageously, the circuit is integrated in an integrated circuit.

### BRIEF DESCRIPTION OF THE DRAWINGS/FIGURES

The above and other features, aspects and advantages of the present invention will be more fully understood when considered with respect to the following detailed description, appended claims and accompanying drawings, wherein:

FIG. 1 shows a circuit of a level translator as known from prior art;

FIG. 2 shows a circuit of a new level translator according to the invention;

Fig. 3 shows a variant of the level translator circuit according to the invention.

### DETAILED DESCRIPTION OF THE INVENTION

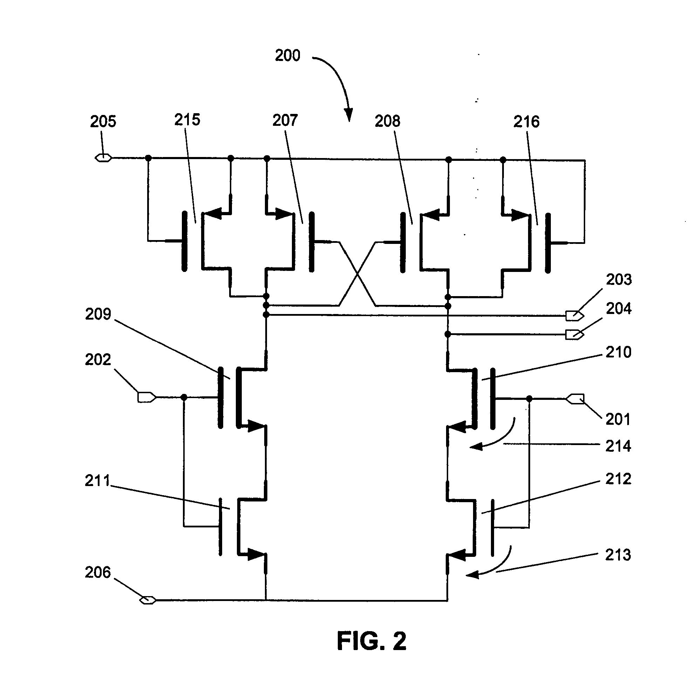

Figure 1 shows a circuit of a level translator circuit 100 for translating a digital signal from a first voltage level to a higher voltage level, as it is known from prior art.

The circuit 100 comprises a first input connector 101 and a second input connector 102 for receiving the digital input signal to be translated, wherein the second input connector 102 is dedicated for receiving the inverted input signal.

Also the circuit 100 has a first output connector 103 and a second output connector 104 for delivering the translated digital signal, wherein the signal on the second output connector 104 is the inverted signal of the first output connector 103.

For power supply the circuit 100 is connected to a voltage supply source - not shown in this drawing - via voltage supply connector 105 and via connector 106, wherein the voltage supplied to voltage supply connector 105 is the voltage of the higher level into which the input signal is to be translated. The voltage supplied to connector 106 is the reference voltage, which in this example is ground. The digital input signal supplied via connectors 101 and 102 thus have the same reference voltage as the digital output signal received via the output connectors 103 and 104.

Circuit 100 comprises two P-MOS transistors 107 and 108 being cross-coupled in that the gate of each transistor is coupled to the drain of other transistor. That is the gate of transistor 107 is connected to the drain of transistor 108 and the gate of transistor 108 is coupled to the drain of transistor 107.

The source of each P-MOS transistor 107 and 108 is connected to the voltage supply source via the voltage supply connector 105.

The drains of the P-MOS transistors 107 and 108 are connected each to a N-MOS transistor, that is the drain of P-MOS transistor 107 is coupled to the source of a first N-MOS transistor 109 and the drain of P-MOS transistor 108 is coupled to a second N-MOS transistor 110.

The drains of the N-MOS transistors 109 and 110 are connected to the ground level via connector 106.

The gates of the N-MOS transistors 109 and 110 are connected to the input connectors 101, 102, that is the gate of the first N-MOS transistor 109 is connected to the inverted digital input signal via the second input connector 102 and N-MOS transistor 110 is connected to the non-inverted digital input signal by means of the first input connector 101.

For illustrating the operation of the circuit 100 it is assumed that the voltage supply source has a voltage of 2.5V, the connector 106 has ground potential and the digital input signal either is 1.0V in its high state or 0V in its low state.

If the digital input signal is in its high state then the second N-MOS transistor 110 is ON, that is conductive. Thus at the source of that transistor 110 the potential is 0V. Also the gate of the first P-MOS transistor 107, which is coupled to the source of the second N-MOS transistor 110, is 0V. As a result this P-MOS transistor is conductive and thus its drain has 2.5V. Vice versa - if the digital input signal is in its high state - the inverted digital signal is low. Consequently the first N-MOS transistor 109 is insulating. The gate of the second P-MOS transistor 108 being connected to the drain of the first P-MOS transistor 107 has a voltage of 2.5V hence the second P-MOS transistor 108 is insulating.

As the output signal is tapped at the drain of first P-MOS transistor 107 and the inverted output signal is tapped at the drain of the second P-MOS transistor 108 respectively the voltage of the first output connector 103 is 2.5V, that is high, and the voltage of the second output connector 104 is 0V, that is low.

If on the contrary the input signal supplied at the first input connector 101 is low and the inverted input signal supplied at the second input connector 102 is high, then the first N-MOS transistor 109 is ON, that is conducting, and thus the second P-MOS transistor 108 is conducting. The second N-MOS transistor 110 is OFF, that is insulating, and the first P-MOS transistor 107 is OFF thus its drain is 0V as the first N-MOS transistor 109 connects the drain of the first P-MOS transistor 107 to ground. So in this case the output signal at the first output connector 103, which is connected to the drain of the first P-MOS transistor 107, is low and the inverted output signal at the second output connector 104 is high, that is 2.5V.

The cross-coupled P-MOS transistors 107 and 108 thus act as a latch that is the drain of one P-MOS transistor is in high state whereas the drain of the other P-MOS transistor is in low state. The state of the latch depends on the state of the digital input signal as described above. As the output signal is tapped from the drains of the P-MOS transistors the state of the output signal is triggered by the state of digital input signal.

The function of the transistors in the circuit is that of switches. However the transistors are not ideal so there is a transient state between the conducting and insulating state of the transistors.

The circuit 100 as described as prior art uses non-native thick layer N-MOS transistors 109 and 110.

The regular thick oxide devices tend to have substantial threshold voltage though and for very advanced processes the lower supply voltage to power the thin oxide transistor based circuits is very low. Thus in advanced technologies it becomes increasingly difficult to turn on N-MOS transistors 109 and 110. In a particular technology the lower supply voltage can be as low as 0.8V while the threshold voltage of the regular thick oxide devices can be as high as 0.75V in a particular environment and process case. In order for the level translator to still work under these conditions the N-MOS transistors 109 and 110 need to be very big in order to have sufficiently low ON resistance to toggle the latch formed by PMOS transistors 107 and 108. This means area of this circuit will be very large, but also the maximum achievable speed drops accordingly as parasitic capacitances increase. Also the circuit can no longer work if the lower supply voltage drops below the threshold voltage of the thick oxide N-MOS transistors 109 and 110, so there is a hard limit for the lower supply voltage under which no signal is passed through anymore.

Hence there is a need for an improved circuit for translating a digital signal from a first voltage level to a second, higher voltage level, which does not have a lower limitation for the lower supply voltage or requires very large transistors in the case the lower supply voltage is very close to but higher then the threshold voltage of the thick layer oxide transistors.

The level translator as described is improved in that the drain of the first and second N-MOS transistors is each coupled to the source of a third and a fourth N-MOS transistor respectively, wherein the first and second N-MOS transistors are native thick oxide layer transistors and the third and fourth N-MOS transistors are thin oxide layer N-MOS transistors each.

The native thick oxide layer N-MOS transistors have the property of having a low threshold voltage for switching the transistors into the ON state that is the conducting state. Also the thick oxide layers enable the transistors to stand a higher voltage between source and drain than the thin oxide layer transistors. On the other hand, the native transistors tend to have a very high leakage current from drain to source when biased with zero gate-source voltage, because their threshold voltage is also about 0 Volts. In reality there will be process spread and some native transistors will have even a negative threshold voltage like - 0.1V, meaning that even when gate and source are connected to ground, the device is still (weakly) in ON state.

It has shown that in a combination of a native thick oxide layer transistor with a thin oxide layer transistor the native thick oxide layer transistor protects the thin oxide layer from high voltage and the thin oxide layer transistor reduces the flow of a leakage current of the native thick oxide layer transistor in the OFF state at the same time. Thus the positive properties of both kinds of transistors are combined.

Turning now to Fig. 2 an embodiment of the level translator according to the invention is explained in more detail.

As can be seen from the drawing the circuit 200 has a lot in common with the circuit 100 as described afore.

Similarly the level translator 200 has a first input connector 201 and a second input connector 202 for receiving the digital input signal to be translated. The second input connector 202 is dedicated for receiving the inverted input signal.

For delivering the translated signal the circuit 200 comprises a first output connector 203 and a second output connector 204, wherein the signal on the second output connector 204 is the inverted signal of the first output connector 203.

The circuit 200 is connected to a voltage supply source via voltage supply connecter 205 and via connector 206. The voltage supplied to the voltage supply connector 205 is the voltage of the higher level into which the input signal is to be translated. In this embodiment the voltage can be assumed to be 2.5V.

The voltage supplied to connector 206 is the reference voltage level, which can be assumed to be ground in this embodiment.

The P-MOS transistors 207 and 208 are cross coupled in that the gate of one is coupled to the drain of the other transistor, that is the gate of the first P-MOS transistor 207 is connected to the drain of the second P-MOS transistor 208 and the gate of the second P-MOS transistor 208 is connected to the drain of the first P-MOS transistor 207 respectively. Both P-MOS transistors 207, 208 are connected to the supply voltage connector with their source.

The drains of the P-MOS transistors 207, 208 are connected each to a N-MOS transistor, namely a first native thick oxide layer N-MOS transistor 209 and a second native thick oxide layer N-MOS transistor 210. So the drain of the first P-MOS transistor 207 is coupled to gate of the other P-MOS transistor 208 as mentioned above and to the source of a first N-MOS transistor 209. The drain of the second P-MOS transistor 208 is similarly coupled to the gate of the first P-MOS transistor 207 and to the source of the second N-MOS transistor 210.

Unlike to the circuit of Fig. 1 the drain of the first N-MOS transistor 201 is coupled to the source of a third N-MOS transistor 211 and the drain of the second N-MOS transistor 210 is connected to a fourth N-MOS transistor 212. The third 211 and fourth N-MOS transistors 212 are thin oxide layer N-MOS transistors.

The drain of the third N-MOS transistor 211 and the fourth N-MOS transistor 212 respectively are coupled each to ground 206.

The gates of the first N-MOS transistor 209 and of the third N-MOS transistor 211 are connected to the second input connector 202 so that the inverted input signal controls the first N-MOS transistor 209 and the third N-MOS transistor 211. Similarly the gates of the second N-MOS transistor 210 and of the fourth N-MOS transistor 212 are connected to the first input connector 201, so that the input signal controls these. Thus the input signal and the inverted input signal control the N-MOS transistors.

To illustrate the operation of the level translator 200 it is assumed that the voltage supply source 205 has a voltage of 2.5V and the connector 206 is connected to ground. Furthermore the input signal and the inverted input signal supplied at the first 201 and second input connector 202 alternate between ground potential and + 1.0 V.

If the input signal supplied at the first input connector 201 is HIGH, that is it has a voltage of 1.0 Volt then there is voltage between the gate and the drain of the fourth N-MOS transistor 212 - as indicated by arrow 213 - of 1.0 V. The fourth N-MOS transistor 212 is a thin oxide layer transistor and thus will open at a voltage of approximately 0.2 Volts. So the fourth N-MOS transistor 212 is ON, that is in its conducting state. This causes that the potential at the drain of the second N-MOS transistor 210 is nearly ground, so that there is a voltage between the gate and the drain of the second N-MOS transistor 201 of nearly 1 V as indicated by arrow 214. As the second N-MOS transistor 210 is a native thick layer transistor it will open at a voltage of approximately 0 Volts between gate and source, so that it will also be ON now, that is in its conducting state.

As a result, if the input signal is HIGH both the second 210 and fourth transistors 212 are ON and thus connecting the second output connector 204 to nearly ground potential, so that the inverted output signal supplied at the second output connector 204 is LOW.

While the input signal is HIGH the inverted input signal is LOW. Thus the gates of the first N-MOS transistor 209 and the third N-MOS transistor 211 have ground potential. Consequently these transistors are OFF, that is insulating.

In this situation the first P-MOS transistor 207, which is connected to the source of the second N-MOS transistor 210 having ground potential here, is ON. Consequently the first output connector 203 being connected to the drain of the first P-MOS transistor 207 nearly has the potential of the supply voltage 2.5 Volts and thus is HIGH.

The second P-MOS transistor 208 is OFF as the gate of it is connected to the drain of the first P-MOS transistor 207 having a voltage of nearly 2.5 Volts. Consequently in this situation the second P-MOS transistor 208 prevents a current flow through the second and fourth N-MOS transistors 210, 212 being ON at this time.

The first and second P-MOS transistors 207, 208 thus form a kind of latch or bistable circuit having two output connectors being the output connectors 203, 204 of the circuit 200 in this case.

Therefore a HIGH state of the input signal and a LOW state of the inverted input signal cause a HIGH state on the first output connector 203 and a LOW state of the second output connector 204, wherein the HIGH state of the output connector is nearly the voltage of the supply voltage.

It is obvious to a person skilled in the art that because of the symmetry of the circuit 200 a LOW state of the input signal and a HIGH state of the inverted input signal cause a LOW state on the first output connector 203 and a HIGH state on the second output connector 204 accordingly.

As mentioned the improved level translator circuit 200 manages to greatly reduce the lower boundary limitation for the low voltage supply compared to prior art. Except for cases where the lower supply voltage is much greater then the threshold voltage of a regular thick oxide layer transistor, the improved level translator provides smaller size and higher speed operation.

Furthermore the native thick oxide layer N-MOS transistors 209 and 210 have the advantage that because of the thickness of the oxide layer they can stand the high voltage of 2.5 Volts. Another advantage is that because they lack the threshold voltage shift operation during production they have very low threshold voltage and so need very little voltage between gate and source to turn ON. In the particular technology the circuit was processed in the threshold voltage for native devices was 0V +/- 100mV. A disadvantage of these transistors is that they tend to have high drain to source leakage current in the OFF state.

The thin oxide layer N-MOS transistors have the advantage of having a very low leakage current in OFF state and they can be very small for realizing a certain ON state channel resistance. The latter is a result of the fact that their minimum channel length can be smaller than the thick oxide devices as well as the fact that their transconductance for a particular size is higher then for thick oxide layer devices due to the thinner oxide layer. Also the threshold voltage is such that the lower supply voltage in the system can always comfortably turn the thin oxide layer transistor ON. The thin oxide transistor parameters are tuned for that, otherwise digital circuitry with the thin oxide transistors would not work well. On the other hand the thin oxide layer transistors cannot stand the high voltage of the supply voltage of 2.5 V.

It has shown that a combination of the two transistors as described according to the invention has the advantage of the speed of the thin layer oxide N-MOS transistor when switching into the OFF state and the advantage of the native thick oxide layer, namely to stand the high voltage of 2.5 V and to have very low voltage operation by virtue of it's extremely low threshold voltage.

For example when looking at the first 209 and third N-MOS transistors 211 the combination of these must be able to stand the voltage of the higher voltage level, when they are in OFF state and the first P-MOS transistor 207 is ON. This is the case as the bigger part of voltage lies at the thick layer oxide transistor 209. Thus the thick layer N-MOS transistor 209 protects the thin oxide layer transistor 211 from a high voltage that would destroy the thin oxide layer transistor 211.

Generally the leakage current can be reduced in that a switching device is put in series with the first and second N-MOS transistors. In a preferred embodiment of the invention the first and second N-MOS transistors are native thick oxide layer transistors and the switching devices are thin oxide layer N-MOS transistors.

Furthermore the circuit 200 may comprise a third 215 and a fourth P-MOS 216 transistor. Each of these transistors is coupled with both its gate and source to the first voltage supply connector 205. The drain of the third P-MOS transistor 215 is coupled to the drain of the first P-MOS transistor 207 and the drain of the fourth P-MOS transistor 216 is coupled to the drain of the second P-MOS transistor 208.

The third and fourth P-MOS transistors 215, 216 are parallel to the first and second P-MOS transistors 207, 208. As their state is that of the parallel first and second P-MOS transistors 207, 208 they act as repeaters of these and reduce any offset voltages due to differing environments.

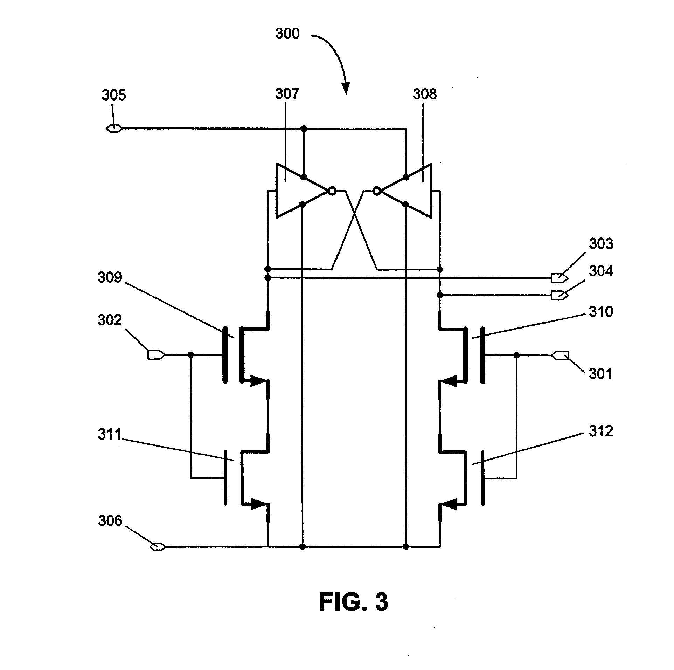

Fig. 3 shows another embodiment of the invention having a lot in common with the circuit 200 as shown in Fig. 2. Similarly the level translator 300 has a first input connector 301 for receiving the digital input signal and a second input connector 302 for receiving the inverted digital input signal. The translated signal and the inverted translated signal are delivered from the first 303 and the second output connector 304. The circuit 300 is connected to a voltage supply source via voltage supply connectors 305 and via connector 306, wherein the voltage supply connector 305 provides the high level voltage and voltage supply connector 306 is the reference voltage.

Unlike to the level translator circuit 200 as shown in Fig. 2 this circuit 300 uses a latch comprising two NOT gate inverters 307 and 308 instead of the cross-coupled P-MOS transistors. The NOT gate inverters are also cross-coupled, thus the output connector of the NOT gate inverter 307 is coupled to the input connector of the NOT gate inverter 308 and vice versa. The output connectors of the NOT gate inverters form the output connectors 303, 304 of the circuit 300.

Similarly to the circuit as in Fig. 2 the circuit 300 comprises a first 309 and a second 310 native thick oxide layer N-MOS transistor and in series to each a first 311 and second thin oxide layer N-MOS 312 transistor. Each pair of a native thick oxide layer N-MOS transistor and a thin oxide layer N-MOS transistor connects an input of the NOT gate inverters to connector 306, which is the reference potential. The gates of the first pair of N-MOS transistors 309, 311 and the second pair of N-MOS transistors 310, 312 is connected the first input connector 302 of the circuit and the second input connector 301 respectively. Thus the state of each pair of N-MOS transistors and thus the state of the latch is controlled by the signal to be translated or its inverted signal respectively.

As circuit 300 differs in the kind of the latch only from the level translator circuit 200 the function is identical as described afore.

In a preferred embodiment the circuit is realized in 90-nanometer CMOS technology.

In the best mode embodiment each thick oxide layer N-MOS transistor 209, 210 is designed as a set of six parallel transistors, each having a channel length of 1.2 micrometer and a channel width of 1.0 micrometer, which can be seen as one transistor having six fingers in parallel, each having a channel length of 1.2 micrometer and a channel width of 1.0 micrometer.

Similarly, each thin oxide layer N-MOS transistor 211, 212 is designed as a set of six parallel transistors, each having a channel length of 0.2 micrometer and a channel width of 1.0 micrometer, which can be seen as a transistor having six fingers in parallel each having a channel length of 0.2 micrometer and a channel width of 1.0 micrometer.

The circuit can be furthermore integrated into an integrated circuit that is into a single chip comprising a plurality of functional circuits.

While the invention has been described with reference to certain embodiments, it will be understood by those skilled in the art that various changes may be made and equivalents may be substituted without departing from the scope of the invention. In addition, many modifications may be made to adapt a particular situation or material to the teachings of the invention without departing from its scope. Therefore, it is intended that the invention not be limited to the particular embodiment disclosed, but that the invention will include all embodiments falling within the scope of the appended claims.

It is to be appreciated that the Detailed Description section, and not the Summary and Abstract sections, is intended to be used to interpret the claims. The Summary and Abstract sections may set forth one or more but not all exemplary embodiments of the present invention as contemplated by the inventor(s), and thus, are not intended to limit the present invention and the appended claims in any way.

## Claims

1. A circuit for translating a digital input signal from a first voltage level to a digital output signal of a second, higher voltage level, having a first input connector for receiving the digital input signal and a second input connector for receiving the inverted digital input signal, a first output connector for delivering the digital output signal and a second output connector for delivering the inverted digital output signal, a first voltage supply connector coupled to the high potential of a voltage supply source and a second voltage supply connector coupled to the reference voltage of the voltage supply source,
comprising:
- a latch coupled to the first voltage supply connector, the higher voltage level being the output voltage level of a first and second output connector of the latch;
- a first and a second N-MOS transistor, the first N-MOS transistor coupled to the first output connector of the latch and the second N-MOS transistor coupled to the second output connector of the latch respectively , and wherein the state of the first transistor is controlled by the state of the first input connector and the state of the second N-MOS transistor is controlled by the state of the second input connector respectively;
- a first and a second switching device, the first switching device connecting the drain of the first N-MOS transistor to the second voltage supply connector and the second switching device connecting the drain of the second N-MOS transistor to the second voltage supply connector, wherein the state of the first switching device is controlled by the state of the first input connector and the state of the second switching device is controlled by the state of the second input connector and wherein the switching time of first and second switching device into the insulating OFF-state is shorter than that of the first and second N-MOS transistor.

2. The circuit of claim 1 wherein the first and second N-MOS transistor each is a native thick oxide layer N-MOS transistor.

3. The circuit of claim 1, wherein the first switching device is a third N-MOS transistor and the second switching device is a fourth N-MOS transistor, the third N-MOS transistor being coupled with its source to the drain of the first N-MOS transistor and with its drain to the second voltage supply connector and with its gate to the second input connector, the fourth N-MOS transistor being coupled with its source to the drain of the second N-MOS transistor and with its drain to the second voltage supply connector and with its gate to the first input connector.

4. The circuit of claim 3, wherein the third and fourth N-MOS transistors are thin oxide layer N-MOS transistors.

5. The circuit of claim 1, wherein the latch comprises a first and a second P-MOS transistor each coupled with its source to the first voltage supply connector and being cross-coupled in that the gate of the first P-MOS transistor is connected to the drain of the second P-MOS transistor and the gate of the second P-MOS transistor is connected to the drain of the first P-MOS transistor respectively, wherein the drain of the first thick oxide layer P-MOS transistor constitutes the first output connector and the drain of the second P-MOS transistor constitutes the second output connector respectively.

6. The circuit of claim 5, the first N-MOS transistor being coupled with its source to the drain of the first thick oxide P-MOS transistor and the second N-MOS transistor being coupled with its source to the drain of the second thick oxide P-MOS transistor respectively, and wherein the gate of the first N-MOS transistor is coupled to the second input connector and the gate of the second N-MOS transistor is coupled to the first input connector respectively.

7. The circuit of claim 5 further comprising a third and a fourth P-MOS transistor, each coupled with its source and gate to the first voltage supply connector, the drain of the third P-MOS transistor coupled to the drain of the first P-MOS transistor and the drain of the fourth P-MOS transistor coupled to the drain of the second P-MOS transistor.

8. The circuit of claim 1, wherein the latch comprises a first and a second NOT gate inverter each coupled to the first voltage supply connector and to the second voltage supply connector for voltage supply, the input of each NOT gate inverter being connected to the output of the other NOT gate inverter, wherein the output connector of first NOT gate inverter constitutes the first output connector of the circuit and the output connector of second NOT gate inverter constitutes the second output connector of the circuit respectively.

9. The circuit of claim 7, the first N-MOS transistor being coupled with its source to the output connector of the first NOT gate inverter and the second N-MOS transistor being coupled with its source to the drain of the second thick NOT gate inverter respectively, and wherein the gate of the first N-MOS transistor is coupled to the second input connector and the gate of the second N-MOS transistor is coupled to the first input connector respectively.

10. The circuit of claim 1, wherein each thick oxide layer N-MOS transistor is designed as a set of six parallel transistors, each transistor having a channel width of 1.0 micrometer and a channel length of 1.2 micrometer, and wherein each thin oxide layer N-MOS transistor is designed as a set of six parallel transistors, each transistor having a channel width of 1.0 micrometer and a channel length of 0.2 micrometer.
